# EUROPÄISCHE PATENTSCHRIFT

(11) **EP 3 202 610 B1**
(45) Veröffentlichungstag und Bekanntmachung des Hinweises auf die Patenterteilung: **28.11.2018**
(21) Anmeldenummer: 17153672.5
(22) Anmeldetag: 30.01.2017
(51) Int. Cl.: B60L 1/00, B60R 16/00

(54) **SCHALTUNGSANORDNUNG**
SWITCHING ASSEMBLY
CIRCUIT

(30) Priorität: 03.02.2016 DE 102016001196
(43) Veröffentlichungstag der Anmeldung: 09.08.2017
(73) Patentinhaber: Audi AG, 85045 Ingolstadt (DE)
(72) Erfinder: Rinkleff, Thomas, 85055 Ingolstadt (DE); Krause, David, 81925 München (DE)

(56) Entgegenhaltungen:
- EP-A1- 1 686 678
- JP-A- 2000 201 044
- US-A- 5 831 842
- US-A1- 2006 049 890

## Beschreibung

Die Erfindung betrifft eine Schaltungsanordnung für ein Bordnetz eines Kraftfahrzeugs sowie ein Bordnetz für ein Kraftfahrzeug.

Ein elektrisches Bordnetz eines Kraftfahrzeugs weist u. a. eine Leistungselektronik auf, die bei einer bestimmten Frequenz getaktet wird. Dabei ist es möglich, dass bei einer Oberwelle dieser Frequenz Stromschwankungen auftreten können, die z. B. bei einer Elektromaschine, die mit der Leistungselektronik verbunden ist, ein akustisches Pfeifen verursachen könnte. Außerdem kann sich ergeben, dass eine Batterie des Bordnetzes, die mit der Leistungselektronik verbunden ist, aufgrund der Stromschwankungen angeregt wird. Das akustische Pfeifen kann als störend empfunden werden und ist demnach zu unterbinden.

Aus der Druckschrift WO 2014/189869 A1 ist ein Transformator mit einem integrierten Schwingkreisfilter bekannt, wobei dieser Schwingkreisfilter induktiv an eine Leistungselektronik gekoppelt ist. Hierdurch ist ein Radio zu entstören.

Ein System und ein Verfahren zur Dämpfung eines Schwingkreises in einem Energiewandlungssystem sind in der Druckschrift US 2012/063179 A1 beschrieben. Hierbei wird ein Schwingkreisfilter verwendet, mit dem ein Strom, der von einer Elektromaschine erzeugt wird, mit einer aktiven Rückkoppelung zu entstören ist.

Ein elektrischer Hochleistungsmotor mit einer elektronischen Kommutierung ist aus der Druckschrift DE 69 727 553 T2 bekannt. Hierbei wird eine Versorgungsleitung mit einem Schlüsselschaltkreis entstört.

Vor diesem Hintergrund werden eine Schaltungsanordnung und ein Bordnetz mit den Merkmalen der unabhängigen Patentansprüche vorgestellt. Ausgestaltungen der Schaltungsanordnung und des Bordnetzes gehen aus den abhängigen Patentansprüchen und der Beschreibung hervor.

Die erfindungsgemäße Schaltungsanordnung ist für ein Bordnetz eines Kraftfahrzeugs vorgesehen und umfasst mindestens einen Saugkreis. Das Bordnetz umfasst eine Leistungselektronik sowie mindestens eine damit verbundene Komponente, wobei die Leistungselektronik mindestens ein Bauteil umfasst, das bei einem Betrieb der Leistungselektronik bei einer Taktfrequenz zu takten ist. Das mindestens eine Bauteil der Leistungselektronik ist über mindestens eine Leitung mit der mindestens einen Komponente des Bordnetzes verbunden, wobei die mindestens eine Leitung mindestens eine Induktivität aufweist. Der mindestens einen Leitung ist der mindestens eine Saugkreis mit einer Induktivität und einer Kapazität zugeordnet, wobei die Induktivität des mindestens einen Saugkreises mit der mindestens einen Induktivität der mindestens einen Leitung gekoppelt ist.

In der Regel ist das mindestens eine Bauteil der Leistungselektronik über mindestens einen Satz Leitungen mit der mindestens einen Komponente des Bordnetzes verbunden, wobei jeder Satz Leitungen mindestens eine Induktivität aufweist, wobei jedem Satz Leitungen jeweils mindestens ein Saugkreis mit einer Induktivität und einer Kapazität zugeordnet ist, wobei die Induktivität des mindestens einen Saugkreises mit der mindestens einen Induktivität eines jeweiligen Satzes Leitungen gekoppelt ist. Üblicherweise ist jeweils eine Komponente über jeweils einen Satz Leitungen mit dem mindestens einen Bauteil der Leistungselektronik verbunden. In Ausgestaltung ist die mindestens eine Komponente neben dem mindestens einen Bauteil ebenfalls in der Leistungselektronik und/oder einem gemeinsamen Gehäuse integriert, wobei die mindestens eine Leitung und der mindestens eine zugeordnete Saugkreis ebenfalls in der Leistungselektronik und/oder dem gemeinsamen Gehäuse integriert sind.

In Ausgestaltung umfasst die Schaltungsanordnung mehrere Saugkreise. Das Bordnetz weist neben der Leistungselektronik als Komponenten einen Energiespeicher sowie eine Elektromaschine auf, wobei der Energiespeicher über einen ersten Satz Leitungen mit dem mindestens einen Bauteil der Leistungselektronik verbunden ist. Das mindestens eine Bauteil der Leistungselektronik ist zudem über einen zweiten Satz Leitungen mit der Elektromaschine verbunden. Jeder Satz Leitungen weist mindestens eine Induktivität auf. Außerdem ist jedem Satz Leitungen jeweils mindestens ein Saugkreis mit einer Induktivität und einer Kapazität zugeordnet, wobei die Induktivität des mindestens einen Saugkreises mit der mindestens einen Induktivität eines jeweiligen Satzes Leitungen gekoppelt ist.

Üblicherweise weist der erste Satz Leitungen zwischen dem Energiespeicher, der als Batterie bzw. Akkumulator ausgebildet ist, und dem mindestens einen Bauteil zwei Leitungen auf, die auch als Traktionsleitungen ausgebildet und/oder zu bezeichnen sind. Die Elektromaschine, die als Generator oder Motor zu betreiben ist, weist in der Regel drei Phasen auf. Üblicherweise weist der zweite Satz Leitungen zwischen dem mindestens einen Bauteil der Leistungselektronik und der Elektromaschine drei Leitungen auf, wobei jede Leitung mit einer Phase der Elektromaschine verbunden ist. Diese Leitungen des zweiten Satzes Leitungen sind üblicherweise als Phasenleitungen ausgebildet und/oder zu bezeichnen.

In Ausgestaltung der Schaltungsanordnung weisen mindestens zwei, d. h. zwei oder drei, in der Regel sämtliche Leitungen jeweils eines Satzes Leitungen eine gemeinsame Induktivität auf. Dabei sind mehrere derartige Leitungen in Ausgestaltung von keinem Schirm, von Einzelschirmen um jede Leitung separat oder von einem sogenannten Summenschirm zum Abschirmen der Leitungen umschlossen. Dieser gemeinsamen Induktivität und somit den mindestens zwei Leitungen ist ein gemeinsamer Saugkreis zugeordnet, dessen Induktivität mit der gemeinsamen Induktivität gekoppelt ist. Demnach ist es möglich, dass der erste Satz Leitungen, der zwei Leitungen aufweist, eine gemeinsame Induktivität für beide Leitungen aufweist, der der eine gemeinsame Saugkreis zugeordnet ist. Im Fall des zweiten Satzes Leitungen, der drei Leitungen umfasst, weisen diese drei Leitungen die gemeinsame Induktivität auf, der ein gemeinsamer Saugkreis zugeordnet ist.

In weiterer Ausgestaltung weist die mindestens eine, üblicherweise jede einzelne Leitung jeweils eines Satzes Leitungen eine eigene Induktivität auf, wobei jeder eigenen Induktivität und somit jeder einzelnen Leitung ein Saugkreis zugeordnet ist, dessen Induktivität mit der Induktivität der jeweiligen Leitung gekoppelt ist.

In einer alternativen oder ergänzenden Ausgestaltung ist für zwei Leitungen eines Satzes Leitungen vorgesehen, dass eine erste Leitung gerade ist und eine zweite Leitung eine Schlaufe umfasst, die zu der ersten Leitung gegenläufig gewickelt ist. Die erste Leitung und die Schlaufe der zweiten Leitung weisen eine gemeinsame Induktivität auf. Dieser gemeinsamen Induktivität ist ein Saugkreis zugeordnet, dessen Induktivität mit der gemeinsamen Induktivität gekoppelt ist. Diese Ausgestaltung ist bspw. für den ersten Satz aus zwei Leitungen vorgesehen.

Die mindestens eine Induktivität der mindestens einen Leitung bzw. des jeweiligen Satzes Leitungen ist als Drossel und/oder Spule ausgebildet.

Die mindestens eine Induktivität der mindestens einen Leitung bzw. des jeweiligen Satzes Leitungen ist weiterhin als Bestandteil mindestens eines Kerns, bspw. eines Ferritkerns, ausgebildet, der die mindestens eine Leitung bzw. den jeweiligen Satz Leitungen umschließt. Dieser mindestens eine Kern weist eine Permeabilität µ ≥ 1 auf und ist bspw. aus ferromagnetischem, oder nanokristallinem Material oder aus Vitroperm®-Material gebildet. Somit ist es möglich, dass für mindestens einen Satz Leitungen ein einziger Kern, bspw. der Ferritkern, vorgesehen ist, der sämtliche Leitungen umschließt. Dieser Ferritkern umfasst wiederum eine Induktivität, üblicherweise die gemeinsame Induktivität für sämtliche Leitungen. Alternativ ist möglich, dass jede einzelne Leitung von einem einzelnen Ferritkern umschlossen ist. Jeder dieser Ferritkerne umfasst jeweils eine Induktivität für eine jeweilige Leitung. Dabei ist der mindestens eine Saugkreis dem mindestens einen Ferritkern zugeordnet. Falls ein Satz Leitungen nur einen gemeinsamen Ferritkern aufweist, ist diesem gemeinsamen Ferritkern ein Saugkreis zugeordnet, dessen Induktivität mit der gemeinsamen Induktivität sämtlicher Leitungen gekoppelt ist. Falls der jeweilige Satz Leitungen mehrere Ferritkerne aufweist, ist jedem einzelnen Ferritkern ein Saugkreis zugeordnet, dessen Induktivität mit der Induktivität des jeweiligen Ferritkerns gekoppelt ist.

Außerdem ist parallel zu der mindestens einen Induktivität des jeweiligen Satzes Leitungen eine Kapazität geschaltet. Falls jede Leitung eines Satzes Leitungen eine eigene Induktivität aufweist, ist parallel zu jeder dieser Induktivitäten eine Kapazität geschaltet. Falls der jeweilige Satz Leitungen eine gemeinsame Induktivität aufweist, ist die Kapazität parallel zu dieser einen gemeinsamen Induktivität geschaltet. Falls die mindestens eine Induktivität des jeweiligen Satzes Leitungen als Bestandteil eines Kerns mit einer magnetischen Permeabilität µ ≥ 1 ausgebildet ist, ist möglich, dass die dazu parallel geschaltete Kapazität ebenfalls als Bestandteil des Kerns ausgebildet ist. Alternativ ist möglich, dass diese Kapazität parallel zu dem Kern geschaltet ist.

Eine Resonanzfrequenz des mindestens einen Saugkreises weist einen n-fachen Wert der Taktfrequenz auf, mit der das mindestens eine Bauteil der Leistungselektronik zu takten ist, wobei n eine ganze Zahl größer gleich 1 ist.

In weiterer Ausgestaltung ist vorgesehen, dass die Resonanzfrequenz des mindestens einen Saugkreises denselben Wert wie die Taktfrequenz oder eine erste, zweite, dritte, ...n-te Oberwelle der Taktfrequenz aufweist, mit der das mindestens eine Bauteil der Leistungselektronik arbeitet. Üblicherweise weist die erste Oberwelle eine Frequenz mit einem Wert auf, der doppelt so hoch wie die Taktfrequenz der Leistungselektronik ist. Demnach ist durch Auswahl der Induktivität und der Kapazität des mindestens einen Saugkreises dessen Resonanzfrequenz auf einen n-fachen Wert der Taktfrequenz der Oberwelle einzustellen, wobei die Resonanzfrequenz bspw. genauso groß, doppelt so groß oder n-mal so groß wie die Taktfrequenz der Leistungselektronik ist.

Der mindestens eine Saugkreis weist eine Induktivität, eine Kapazität und einen Widerstand auf, die in Reihe geschaltet sind, wobei über einen Wert des Widerstands eine Bandbreite des mindestens einen Saugkreises einzustellen ist. In der Regel weist die Induktivität des mindestens einen Saugkreises einen m-fachen Wert der Induktivität der mindestens einen Leitung auf. Hierbei ist m eine ganze Zahl größer oder gleich 1. Eine n-fache Resonanzfrequenz des mindestens einen Saugkreises ist durch Wahl der Kapazität einzustellen.

Das erfindungsgemäße Bordnetz für ein Kraftfahrzeug umfasst eine Leistungselektronik sowie mindestens eine damit verbundene Komponente, wobei die Leistungselektronik mindestens ein Bauteil umfasst. Die mindestens eine Komponente und das mindestens eine Bauteil sind über mindestens eine Leitung miteinander verbunden, wobei das mindestens eine Bauteil bei einem Betrieb der Leistungselektronik mit einer Taktfrequenz zu takten ist, wobei das Bordnetz eine Ausführungsform der voranstehend vorgestellten Schaltungsanordnung aufweist.

Die mindestens eine Komponente ist bspw. als Energiespeicher ausgebildet, der über einen Satz aus zwei Leitungen mit dem mindestens einen Bauteil der Leistungselektronik verbunden ist. Alternativ oder ergänzend ist die mindestens eine Komponente bspw. als Elektromaschine ausgebildet, die über einen Satz aus drei Leitungen mit dem mindestens einen Bauteil der Leistungselektronik verbunden ist. Alternativ oder ergänzend ist die mindestens eine Komponente des Bordnetzes als Ladegerät, elektrischer Klimakompressor oder Hochvolt-Heizer ausgebildet. Mehrere zu einem Satz zusammengefasste Leitungen sind als Summenleitung ausgebildet und/oder zu bezeichnen.

Weiterhin ist möglich, dass die mindestens eine Komponente, das mindestens eine Bauteil der Leistungselektronik sowie die mindestens eine Leitung als Bestandteile eines Geräts des Bordnetzes ausgebildet und bspw. in einem Gehäuse angeordnet sind. Diesbezüglich ist in einer Variante vorgesehen, dass die Leistungselektronik und die Elektromaschine als Bestandteile eines Geräts ausgebildet sind. Üblicherweise umfasst die Elektromaschine als mechanische Komponenten einen Rotor und einen Stator, die über die mindestens eine Leitung mit dem mindestens einen Bauteil der Leistungselektronik verbunden sind. Der mindestens eine Saugkreis, der der mindestens einen Leitung zugeordnet ist, ist in Ausgestaltung ebenfalls als Bestandteil des Geräts ausgebildet und in demselben Gehäuse angeordnet. Außerdem ist möglich, dass die mindestens eine Komponente, die mit dem mindestens einen Bauteil der Leistungselektronik über die mindestens eine Leitung verbunden ist, ebenfalls als Bestandteil der Leistungselektronik ausgebildet und somit in demselben Gerät und/oder Gehäuse angeordnet ist. Demnach ist auch der mindestens eine Saugkreis als Bestandteil der Leistungselektronik ausgebildet.

Die mindestens eine Leitung ist von einem Kern aus einem Material umschlossen, das eine magnetische Permeabilität µ größer als 1 aufweist.

Weitere Vorteile und Ausgestaltungen der Erfindung ergeben sich aus der Beschreibung und den beiliegenden Zeichnungen.

Es versteht sich, dass die voranstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

Die Erfindung ist anhand von Ausführungsformen in den Zeichnungen schematisch dargestellt und wird unter Bezugnahme auf die Zeichnungen schematisch und ausführlich beschrieben.
Figur 1 zeigt in schematischer Darstellung ein Beispiel für einen Saugkreis, der als Bestandteil einer Ausführungsform der erfindungsgemäßen Schaltungsanordnung ausgebildet ist.
Figur 2 zeigt in schematischer Darstellung ein Beispiel eines Bordnetzes, für das eine Ausführungsform einer erfindungsgemäßen Schaltungsanordnung vorzusehen ist.
Figur 3 zeigt in schematischer Darstellung eine erste Ausführungsform des erfindungsgemäßen Bordnetzes auf Basis des Bordnetzes aus Figur 2 und eine erste Ausführungsform der erfindungsgemäßen Schaltungsanordnung.
Figur 4 zeigt in schematischer Darstellung eine zweite Ausführungsform des erfindungsgemäßen Bordnetzes auf Basis des Bordnetzes aus Figur 2 und eine zweite Ausführungsform der erfindungsgemäßen Schaltungsanordnung.
Figur 5 zeigt in schematischer Darstellung ein Detail einer dritten Ausführungsform des erfindungsgemäßen Bordnetzes auf Basis des Bordnetzes aus Figur 2 und eine dritte Ausführungsform der erfindungsgemäßen Schaltungsanordnung.

Die Figuren werden zusammenhängend und übergreifend beschrieben. Gleichen Komponenten sind dieselben Bezugsziffern zugeordnet.

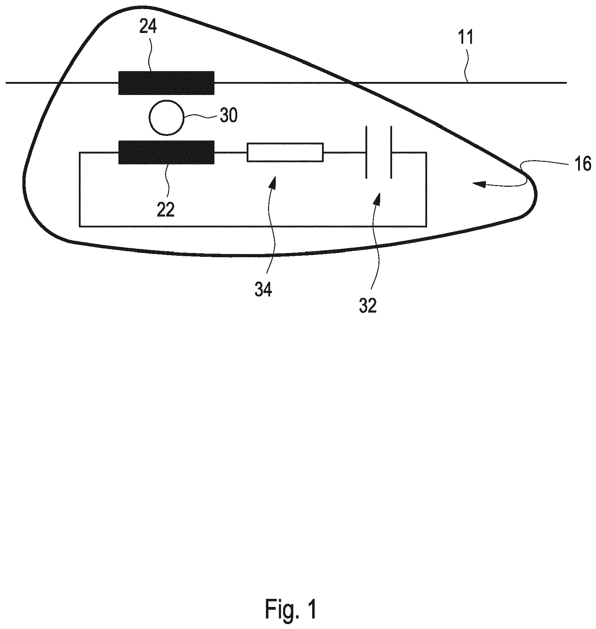

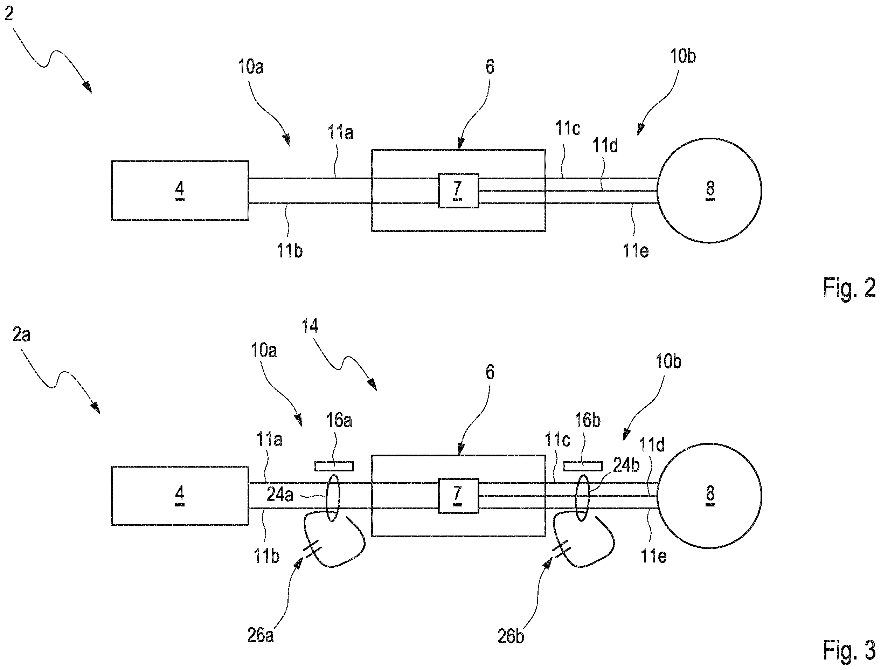

Der in Figur 1 schematisch dargestellte Saugkreis 16 weist eine Induktivität 22, eine Kapazität 32 bzw. einen Kondensator sowie einen elektrischen Widerstand 34 auf. Dabei ist dieser elektrische Saugkreis 16 als Bestandteil einer Ausführungsform der elektrischen Schaltungsanordnung 14, 18 oder 20, wie sie anhand einer der Figuren 3 bis 5 dargestellt ist, ausgebildet. Der in Figur 1 schematisch dargestellte Saugkreis 16 steht hierbei repräsentativ für jeden Saugkreis 16a, 16b, 16c, 16d, 16e, 16f, 16g, 16h einer der Ausführungsformen der Schaltungsanordnung 14, 18, 20. Weiterhin zeigt Figur 1 mindestens eine Leitung 11 eines Bordnetzes 2, 2a, 2b, 2c, wie es anhand einer der Figuren 2 bis 5 nachfolgend schematisch dargestellt ist.

Dabei repräsentiert und/oder umfasst diese mindestens eine Leitung 11 mindestens eine Leitung 11a, 11b, 11c, 11d, 11e, 11f des jeweiligen Bordnetzes 2, 2a, 2b, 2c und demnach ggf. auch einen Satz 10a, 10b, 10c aus mehreren Leitungen 11a, 11b, 11c, 11d, 11e, 11f, wie sie anhand der nachfolgenden Figuren 2 bis 5 schematisch dargestellt sind.

Die mindestens eine Leitung 11 bzw. 11a, 11b, 11c, 11d, 11e, 11f umfasst mindestens eine Induktivität 24. Zur Realisierung einer Ausführungsform der erfindungsgemäßen Schaltungsanordnung 14, 18, 20 ist vorgesehen, dass der Saugkreis 16 der mindestens einen Leitung 11 bzw. 11a, 11b, 11c, 11d, 11e, 11f zugeordnet ist. Hierbei ist die Induktivität 22 des Saugkreises 16 bzw. 16a, 16b, 16c, 16d, 16e, 16f, 16g, 16h neben der mindestens einen Induktivität 24 der mindestens einen Leitung 11 bzw. 11a, 11b, 11c, 11d, 11e, 11f angeordnet und mit dieser induktiv gekoppelt, wobei eine derartige induktive Kopplung in Figur 1 durch einen Kreis 30 angedeutet ist. Allerdings ist der Saugkreis 16 bzw. 16a, 16b, 16c, 16d, 16e, 16f, 16g, 16h von der mindestens einen Leitung 11 bzw. 11a, 11b, 11c, 11d, 11e, 11f galvanisch entkoppelt.

Das in Figur 2 schematisch dargestellte Beispiel des Bordnetzes 2 für ein Kraftfahrzeug umfasst als Komponenten einen als Batterie ausgebildeten Energiespeicher 4, eine Leistungselektronik 6, die als mindestens ein Bauteil 7 u. a. mindestens einen Pulswechselrichter umfasst, und eine Elektromaschine 8, die entweder als Generator oder als Motor zu betreiben ist. Falls die Elektromaschine 8 als Generator betrieben wird, wird mit dieser mechanische Energie in elektrische Energie umgewandelt. Falls die Elektromaschine 8 dagegen als Motor betrieben wird, ist mit der Elektromaschine 8 elektrische Energie in mechanische Energie umzuwandeln. Hier ist vorgesehen, dass die Elektromaschine 8 drei Phasen aufweist.

Der Energiespeicher 4 und das mindestens eine Bauteil 7 der Leistungselektronik 6 sind hier über einen ersten Satz 10a aus zwei Leitungen 11a, 11b, hier Traktionsleitungen, verbunden. Außerdem sind die Leistungselektronik 6 und die Elektromaschine 8 über einen zweiten Satz 10b von hier drei Leitungen 11c, 11d, 11e, hier Phasenleitungen, miteinander verbunden. Dabei ist jeder Phase der Elektromaschine 8 eine Leitung 11c, 11d, 11e zugeordnet, die den zweiten Satz 10b Leitungen bilden.

Das vorgestellte Bordnetz 2 ist für ein Kraftfahrzeug vorgesehen, das mit mindestens einer Elektromaschine 8, wie sie hier vorgestellt wird, anzutreiben bzw. fortzubewegen ist. Demnach ist das Kraftfahrzeug entweder als reines Elektrofahrzeug, das rein elektrisch anzutreiben ist, oder als Hybridfahrzeug ausgebildet. Falls das Kraftfahrzeug als Hybridfahrzeug ausgebildet ist, weist es zum Antreiben neben der mindestens einen Elektromaschine 8 mindestens einen weiteren Motor, üblicherweise einen Verbrennungsmotor, auf. Weiterhin ist möglich, dass ein Bordnetz 2 mehrere Leistungselektroniken 6 und Elektromaschinen 8 aufweist.

Das mindestens eine Bauteil 7 der Leistungselektronik 6 wird beim Betrieb des Bordnetzes 2 mit einer einstellbaren Taktfrequenz getaktet. Dabei weist diese Taktfrequenz üblicherweise einen Wert von mehreren tausend Hertz auf. Eine Oberwelle, bspw. eine erste Oberwelle, dieser Taktfrequenz weist eine Frequenz mit einem Wert auf, die bzw. der doppelt so groß wie der Wert der Frequenz der Taktfrequenz ist. Falls die Taktfrequenz des mindestens einen Bauteils 7 einen Wert von 9 kHz aufweist, weist die erste Oberwelle eine Frequenz mit einem Wert von 18 kHz auf.

Beim Betrieb der Leistungselektronik 6 kann sich ergeben, dass das mindestens eine Bauteil 7 ein elektromagnetisches Feld entwickelt, das sich auch auf den Energiespeicher 4 sowie die Elektromaschine 8 auswirkt. Dabei kann sich ergeben, dass die Elektromaschine 8 bei der Frequenz einer Oberwelle zu einem akustisch hörbaren Pfeifen angeregt wird. Weiterhin ist es möglich, dass der Energiespeicher 4 ebenfalls durch das elektromagnetische Feld des mindestens einen Bauteils 7 der Leistungselektronik 6 angeregt wird. Demnach kann ein Betrieb des Energiespeichers 4 und der Elektromaschine 8 durch das elektromagnetische Feld des mindestens einen Bauteils 7 der Leistungselektronik 6 gestört werden. Weiterhin ist möglich, dass das elektromagnetische Feld über die Leitungen 11a, 11b, 11c, 11d, 11e abgestrahlt wird. Es ist auch möglich, dass weitere, hier nicht dargestellte Komponenten des Bordnetzes 2 oder des Kraftfahrzeugs aufgrund des abgestrahlten elektromagnetischen Felds des mindestens einen Bauteils 7 der Leistungselektronik 6 gestört werden.

Die erste Ausführungsform der erfindungsgemäßen Schaltungsanordnung 14 für die erste Ausführungsform des Bordnetzes 2a ist in Figur 3 schematisch dargestellt und umfasst einen ersten Saugkreis 16a und einen zweiten Saugkreis 16b.

In Figur 3 ist weiterhin eine erste Induktivität 24a gezeigt, die hier den beiden Leitungen 11a, 11b des ersten Satzes 10a Leitungen 11a, 11b zugeordnet ist. Dieser gemeinsamen Induktivität 24a ist der erste Saugkreis 16a zugeordnet, dessen Induktivität 22 mit der gemeinsamen Induktivität 24a des ersten Satzes 10a Leitungen 11a, 11b gekoppelt ist. Hierbei ist weiterhin vorgesehen, dass die gemeinsame Induktivität 24a als Bestandteil eines Kerns mit einer magnetischen Permeabilität µ > 1 ausgebildet ist, der beide Leitungen 11a, 11b umschließt. Parallel zu der gemeinsamen Induktivität 24a ist hier eine Kapazität 26a geschaltet.

Eine zweite Induktivität 24b ist hier dem zweiten Satz 10b, der die Leitungen 11c, 11d, 11e umfasst, zugeordnet. Dieser zweiten Induktivität 24b, die als gemeinsame Induktivität 24b für sämtliche Leitungen 11c, 11d, 11e ausgebildet ist, ist der zweite Saugkreis 16b zugeordnet, dessen Induktivität 22 mit der gemeinsamen Induktivität 24b des zweiten Satzes 10b Leitungen 11c, 11d, 11e gekoppelt ist. Außerdem ist die gemeinsame Induktivität 24b als Bestandteil eines Kerns, hier eines Ferritkerns, ausgebildet, der alle drei Leitungen 11c, 11d, 11e umschließt. Alternativ hierzu ist der Kern aus nanokristallinem Material oder einem anderen Material mit einer Permeabilität > 1. Parallel zu der gemeinsamen Induktivität 24b ist hier eine Kapazität 26b geschaltet.

Die Leitungen 11a, 11b, 11c, 11d, 11e sind zumindest zwischen der Leistungselektronik 6 und den Komponenten, d. h. dem Energiespeicher 4 und der Elektromaschine 8 des Bordnetzes 2a angeordnet. Weiterhin ist hier in Ausgestaltung vorgesehen, dass diese Leitungen 11a, 11b, 11c, 11d, 11e zumindest teilweise auch innerhalb der Leistungselektronik 6 angeordnet und mit dem mindestens einen Bauteil 7 verbunden sind. In Ausgestaltung ist mindestens eine Leitung 11a, 11b, 11c, 11d, 11e teilweise innerhalb eines Gehäuses der Leistungselektronik 6 angeordnet. Eine gemeinsame Induktivität 24a, 24b ist, wie anhand von Figur 3 explizit gezeigt, zwischen der Leistungselektronik 6 und dem Energiespeicher 4 oder zwischen der Leistungselektronik 6 und der Elektromaschine 8 angeordnet. Es ist auch möglich, dass die Induktivität 24a, 24b zwischen dem mindestens einen Bauteil 7 und dem Energiespeicher 4 oder zwischen dem mindestens einen Bauteil 7 und der Elektromaschine 8 innerhalb des Gehäuses der Leistungselektronik 6, bspw. zwischen einem Anschluss der jeweiligen Leitung 11a, 11b, 11c, 11d, 11e und dem mindestens einen Bauteil 7 angeordnet ist. Entsprechend ist es möglich, dass ein Saugkreis 16a, 16b, der der Induktivität 24a, 24b zugeordnet ist, außerhalb des Gehäuses der Leistungselektronik 6 oder innerhalb des Gehäuses, in der Regel zwischen einem jeweiligen Leistungsanschluss und dem mindestens einen Bauteil 7 angeordnet ist.

In Ausgestaltung ist das mindestens eine Bauteil 7 der Leistungselektronik 6 bspw. als Bipolartransistor mit isolierter Gate-Elektrode (IGBT) ausgebildet. Falls Schütze des als Batterie ausgebildeten Energiespeichers 4 aufgrund des elektromagnetischen Felds des mindestens einen Bauteils 7 gestört werden könnten, ist hier der Saugkreis 16a zwischen dem mindestens einen Bauteil 7 und den Schützen des Energiespeichers 4 anzuordnen. In Ausgestaltung ist möglich, dass die Leitungen 11a, 11b auch teilweise innerhalb eines Gehäuses des Energiespeichers 4 verlaufen und die Induktivität 24a ebenfalls innerhalb des Gehäuses des Energiespeichers 4 oder der Leistungselektronik 6 angeordnet ist. In diesem Fall ist der erste Saugkreis 16a auch teilweise innerhalb des Gehäuses, bspw. zwischen den Schützen und Leitungsanschlüssen für die Leitungen 11a, 11b, angeordnet. Entsprechend ist auch möglich, dass die Leitungen 11c, 11d, 11e sowie die gemeinsame Induktivität 24 ebenfalls innerhalb eines Gehäuses der Elektromaschine 8 oder der Leistungselektronik 6 angeordnet sind. In diesem Fall ist in Ausgestaltung möglich, den Saugkreis 16b, der der Induktivität 24b zuzuordnen ist, ebenfalls innerhalb des Gehäuses der Elektromaschine 8 anzuordnen.

Mit dieser ersten Ausführungsform der Schaltungsanordnung 14 wird für das Bordnetz 2a eine sogenannte Common-Mode-Entstörung bewirkt. Je nach Definition ist hier vorgesehen, dass das mindestens eine Bauteil 7 der Leistungselektronik 6 als Störquelle und der Energiespeicher 4 sowie die Elektromaschine 8 jeweils als Störsenken ausgebildet und/oder zu bezeichnen sind. Die Saugkreise 16a, 16b sind hier zwischen der Leistungselektronik 6 und jeweils einer weiteren Komponente, d. h. dem Energiespeicher 4 sowie der Elektromaschine 8 des Bordnetzes 2a angeordnet.

Bei der zweiten Form des erfindungsgemäßen Bordnetzes 2b ist vorgesehen, dass jede Leitung 11a, 11b, 11c, 11d, 11e zwischen dem mindestens einen Bauteil 7 der Leistungselektronik 6 und einer jeweiligen Komponente, d. h. dem Energiespeicher 4 oder der Elektromaschine 8 des Bordnetzes 2b eine eigene Induktivität 24c, 24d, 24e, 24f, 24g aufweist, zu der jeweils eine Kapazität 26c, 26d, 26e, 26f, 26g parallel geschaltet ist. Dabei ist hier weiterhin vorgesehen, dass mindestens eine jeweilige Induktivität 24c, 24d, 24e, 24f, 24g als Bestandteil eines Ferritkerns ausgebildet ist, der die jeweilige Leitung 11a, 11b, 11c, 11d, 11e umschließt.

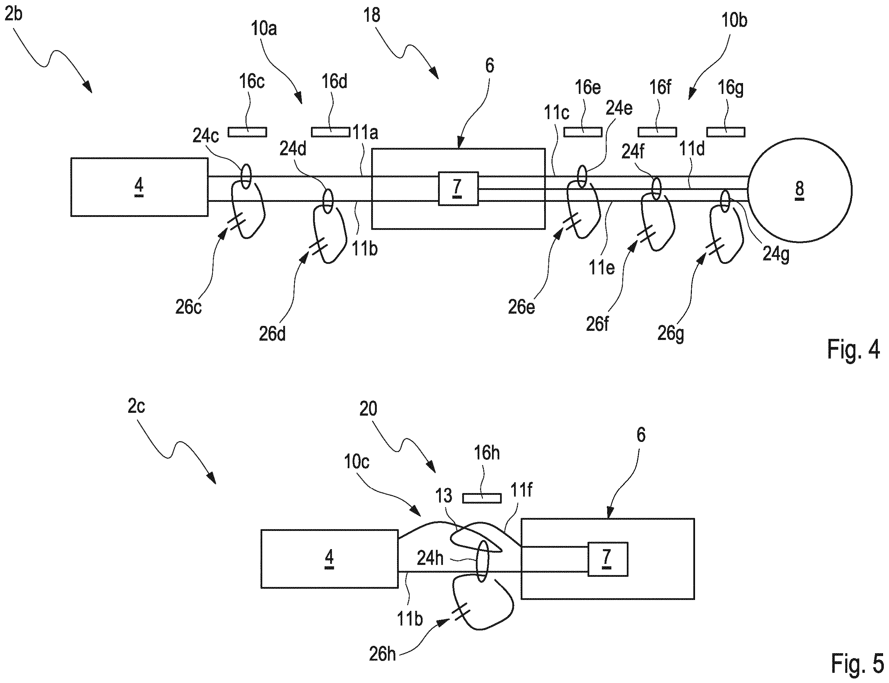

Bei der anhand von Figur 4 vorgestellten zweiten Ausführungsform der Schaltungsanordnung 18 ist jeder Induktivität 24c, 24d, 24e, 24f, 24g jeweils einer Leitung 11a, 11b, 11c, 11d, 11e ein Saugkreis 16c, 16d, 16e, 16f, 16g, wie er anhand des Saugkreises 16 aus Figur 1 repräsentativ dargestellt ist, zugeordnet. Hierbei ist eine jeweilige Induktivität 22 eines Saugkreises 16c, 16d, 16e, 16f, 16g mit der jeweiligen Induktivität 24c, 24d, 24e, 24f, 24g der jeweiligen Leitung 11a, 11b, 11c, 11d, 11e gekoppelt.

Durch Vorsehen jeweils einer Induktivität 24c, 24d, 24e, 24f, 24g für jeweils eine Leitung 11a, 11b, 11c, 11d, 11e, der jeweils ein Saugkreis 16c, 16d, 16e, 16f, 16g zugeordnet ist, ist mit der zweiten Ausführungsform der Schaltungsanordnung 2b eine differentielle Entstörung zu erreichen.

Bei dem Detail der dritten Ausführungsform des Bordnetzes 11c, das in Figur 5 schematisch dargestellt ist, sind lediglich die Leistungselektronik 6 und der Energiespeicher 4 als Komponenten des Bordnetzes 2c gezeigt. Hierbei ist das mindestens eine Bauteil 7 der Leistungselektronik 6 über Leitungen 11b, 11f mit dem Energiespeicher 4 verbunden, wobei diese beiden Leitungen 11b, 11f einen weiteren Satz 10c Leitungen 11b, 11f bilden. Hierbei ist vorgesehen, dass die Leitung 11b zwischen dem mindestens einen Bauteil 7 und im Energiespeicher 4 direkt und/oder gerade verläuft, wohingegen die Leitung 11f eine gegenläufige Wicklung und somit eine Schlaufe 13 aufweist. Die Leitung 11b und die Schlaufe 13 der Leitung 11f und somit beide Leitungen 11b, 11f weisen eine gemeinsame Induktivität 24h auf, zu der eine Kapazität 26h parallel geschaltet ist. Dabei ist möglich, dass die Induktivität 24h als Bestandteil eines Kerns, bspw. eines Ferritkerns, der die Leitung 11b und die Schlaufe 13 der Leitung 11f umschließt, ausgebildet ist.

Die in Figur 5 gezeigte dritte Ausführungsform der Schaltungsanordnung 20 umfasst hier einen Saugkreis 16h, der entsprechend dem Saugkreis 16 aus Figur 1 ausgebildet ist. Dabei ist dieser Saugkreis 16h der gemeinsamen Induktivität 24h des Satzes 10c Leitungen 11b, 11f zugeordnet. Die Induktivität 22 des Saugkreises 16h ist hierbei mit der gemeinsamen Induktivität 24h des Satzes 10c Leitungen 11b, 11f gekoppelt.

Sämtliche Saugkreise 16, 16a, 16b, 16c, 16d, 16e, 16f, 16g, 16h umfassen eine Reihenschaltung aus der Kapazität 32 und der Induktivität 22 (wie beispielhaft in Figur 1 für Saugkreis 16 dargestellt), die als Drossel oder Spule ausgebildet ist. Üblicherweise ist der Ohmsche Widerstand 34 gering einzustellen. Eine Resonanzfrequenz f_{R} ist abhängig von einem Wert L der Induktivität 22 sowie einem Wert C der Kapazität und beträgt f_{R} = 0,5/π * (LC)^{-0,5}. Eine Bandbreite der Resonanzfrequenz f_{R} ist durch den Widerstand 34 einzustellen. Außerdem ist die Resonanzfrequenz abhängig von der Taktfrequenz des mindestens einen Bauteils 7 einzustellen, wobei Werte L, C der Induktivität 22 und der Kapazität 32 zu wählen sind. In der Regel entspricht die Resonanzfrequenz einem ganzzahligen n-fachen der Taktfrequenz. Jeder Saugkreis 16, 16a, 16b, 16c, 16d, 16e, 16f, 16g, 16h ist über seine Induktivität 22 mit einer jeweiligen Induktivität 24, 24a, 24b, 24c, 24d, 24e, 24f, 24g, 24h für die mindestens eine Leitung 11 bzw. 11a, 11b, 11c, 11d, 11e, 11f induktiv zu koppeln. In Ausgestaltung wird der Wert C der Induktivität 22 an einen jeweiligen Wert einer Induktivität 24, 24a, 24b, 24c, 24d, 24e, 24f, 24g, 24h des Bordnetzes 2, 2a, 2b, 2c als potentialfreies System des Kraftfahrzeugs angepasst. Dabei ist das Bordnetz 2, 2a, 2b, 2c als Gleichstromnetz und/oder Dreiphasennetz ausgebildet. Der Wert C der Kapazität 34 ist unter Berücksichtigung der Taktfrequenz des mindestens einen Bauteils 7 oder einem ganzzahligen Vielfachen dieser Taktfrequenz als Zielfrequenz zu wählen.

Die Frequenz einer Oberwelle, bspw. der ersten Oberwelle, der Taktfrequenz des mindestens einen Bauteils 7 der Leistungselektronik beträgt bspw. 18 kHz und variiert bspw. in Abhängigkeit einer Drehzahl der Elektromaschine 8 und einer Zahl an Polpaaren der Elektromaschine. Unter Berücksichtigung einer derartigen Abweichung der Frequenz der Oberwelle ist ein jeweiliger Saugkreis 16, 16a, 16b, 16c, 16d, 16e, 16f, 16g, 16h breitbandig auszuführen, was wiederum durch Dimensionierung des Widerstands zu realisieren ist.

In Ausgestaltung kann die Induktivität 22 des Saugkreises 16, 16a, 16b, 16c, 16d, 16e, 16f, 16g, 16h aus Vitroperm® oder einem Nanokristall gebildet sein und einen hohen µ-Wert aufweisen, wodurch der Widerstand direkt durch die Induktivität 22 zu erzeugen ist. Eine mit einem jeweiligen Saugkreis 16, 16a, 16b, 16c, 16d, 16e, 16f, 16g, 16h erzielbare Dämpfung der elektromagnetischen Strahlung des mindestens einen Bauteils 7 ist auch von einem Wert einer jeweiligen Induktivität 24, 24a, 24b, 24c, 24d, 24e, 24f, 24g, 24h der mindestens einen Leitung 11 bzw. 11a, 11b, 11c, 11d, 11e, 11f abhängig, wobei ein Wert einer jeweiligen Induktivität 24, 24a, 24b, 24c, 24d, 24e, 24f, 24g, 24h bspw. durch mehrfaches Wickeln eines hier als Ferritkern ausgebildeten Kerns, der die jeweilige Induktivität 24, 24a, 24b, 24c, 24d, 24e, 24f, 24g, 24h umfasst, und/oder durch Verwendung einer Drossel als Induktivität 24, 24a, 24b, 24c, 24d, 24e, 24f, 24g, 24h zu erhöhen ist.

Falls ein Bordnetz 2, 2a, 2b, 2c mehrere Leistungselektroniken 6 und Elektromaschinen 8 aufweist, kann der mindestens eine Saugkreis 16, 16a, 16b, 16c, 16d, 16e, 16f, 16g, 16h für mindestens eine Leistungselektronik 6, d. h. für eine Leistungselektronik 6, mehrere Leistungselektroniken 6 oder sämtliche Leistungselektroniken 6 eingesetzt werden. Bei mehreren Saugkreisen 16, 16a, 16b, 16c, 16d, 16e, 16f, 16g, 16h können diese unterschiedliche Resonanzfrequenzen aufweisen.

## Patentansprüche

1. Schaltungsanordnung für ein Bordnetz (2, 2a, 2b, 2c) eines Kraftfahrzeugs, wobei die Schaltungsanordnung (14, 18, 20) mindestens einen Saugkreis (16, 16a, 16b, 16c, 16d, 16e, 16f, 16g, 16h) und das Bordnetz (2, 2a, 2b, 2c) eine Leistungselektronik (6) sowie mindestens eine damit verbundene Komponente umfasst, wobei die Leistungselektronik (6) mindestens ein Bauteil (7) umfasst, das bei einem Betrieb der Leistungselektronik (6) bei einer Taktfrequenz zu takten ist, wobei das mindestens eine Bauteil (7) über mindestens eine Leitung (11, 11a, 11b, 11c, 11d, 11e, 11f) mit der mindestens einen Komponente verbunden ist, wobei die mindestens eine Leitung (11, 11a, 11b, 11c, 11d, 11e, 11f) mindestens eine Induktivität (24, 24a, 24b, 24c, 24d, 24e, 24f, 24g, 24h) aufweist, wobei der mindestens einen Leitung (11, 11a, 11b, 11c, 11d, 11e, 11f) der mindestens eine Saugkreis (16, 16a, 16b, 16c, 16d, 16e, 16f, 16g, 16h) mit einer Induktivität (24, 24a, 24b, 24c, 24d, 24e, 24f, 24g, 24h) und einer Kapazität zugeordnet ist, wobei die Induktivität (24, 24a, 24b, 24c, 24d, 24e, 24f, 24g, 24h) des mindestens einen Saugkreises (16, 16a, 16b, 16c, 16d, 16e, 16f, 16g, 16h) mit der mindestens einen Induktivität (24, 24a, 24b, 24c, 24d, 24e, 24f, 24g, 24h) der mindestens einen Leitung (11, 11a, 11b, 11c, 11d, 11e, 11f) gekoppelt ist.

2. Schaltungsanordnung nach Anspruch 1, bei der das mindestens eine Bauteil (7) der Leistungselektronik (6) über mindestens einen Satz (10a, 10b, 10c) Leitungen (11, 11a, 11b, 11c, 11d, 11e, 11f) mit der mindestens einen Komponente des Bordnetzes (2, 2a, 2b, 2c) verbunden ist, wobei jeder Satz (10a, 10b, 10c) Leitungen (11, 11a, 11b, 11c, 11d, 11e, 11f) mindestens eine Induktivität (24, 24a, 24b, 24c, 24d, 24e, 24f, 24g, 24h) aufweist, wobei jedem Satz (10a, 10b, 10c) Leitungen (11, 11a, 11b, 11c, 11d, 11e, 11f) jeweils mindestens ein Saugkreis (16, 16a, 16b, 16c, 16d, 16e, 16f, 16g, 16h) mit einer Induktivität (22) zugeordnet ist, wobei die Induktivität (22) des mindestens einen Saugkreises (16, 16a, 16b, 16c, 16d, 16e, 16f, 16g, 16h) mit der mindestens einen Induktivität (24, 24a, 24b, 24c, 24d, 24e, 24f, 24g, 24h) eines jeweiligen Satzes (10a, 10b, 10c) Leitungen (11, 11a, 11b, 11c, 11d, 11e, 11f) gekoppelt ist.

3. Schaltungsanordnung nach Anspruch 2, bei der mindestens zwei Leitungen (11, 11a, 11b, 11c, 11d, 11e, 11f) jeweils eines Satzes (10a, 10b, 10c) Leitungen (11, 11a, 11b, 11c, 11d, 11e, 11f) eine gemeinsame Induktivität (24a, 24b, 24h) aufweisen, wobei dieser gemeinsamen Induktivität (24a, 24b, 24h) ein Saugkreis (16a, 16b, 16h) zugeordnet ist, dessen Induktivität (22) mit der gemeinsamen Induktivität (24a, 24b, 24h) gekoppelt ist.

4. Schaltungsanordnung nach Anspruch 2 oder 3, bei der mindestens eine Leitung (11, 11a, 11b, 11c, 11d, 11e, 11f)jeweils eines Satzes (10a, 10b, 10c) Leitungen (11, 11a, 11b, 11c, 11d, 11e, 11f) eine eigene Induktivität (24c, 24d, 24e, 24f, 24g) aufweist, wobei jeder eigenen Induktivität (24c, 24d, 24e, 24f, 24g) ein Saugkreis (16, 16c, 16d, 16e, 16f, 16g) zugeordnet ist, dessen Induktivität (22) mit der eigenen Induktivität (24c, 24d, 24e, 24f, 24g) gekoppelt ist.

5. Schaltungsanordnung nach einem der Ansprüche 2 bis 4, bei der von zwei Leitungen (11b, 11f) eines Satzes (10c) Leitungen (11b, 11f) eine erste Leitung (11b) gerade verläuft und eine zweite Leitung (11f) eine Schlaufe (13) umfasst, die zu der ersten Leitung (11b) gegenläufig gewickelt ist, wobei die erste Leitung (11b) und die Schlaufe (13) der zweiten Leitung (11f) eine gemeinsame Induktivität (24h) aufweisen, wobei dieser gemeinsamen Induktivität (24h) ein Saugkreis (16, 16h) zugeordnet ist, dessen Induktivität (22) mit der gemeinsamen Induktivität (24h) gekoppelt ist.

6. Schaltungsanordnung nach einem der voranstehenden Ansprüche, bei der die mindestens eine Induktivität (24, 24a, 24b, 24c, 24d, 24e, 24f, 24g, 24h) der mindestens einen Leitung (11, 11a, 11b, 11c, 11d, 11e, 11f) als Drossel ausgebildet ist.

7. Schaltungsanordnung nach einem der voranstehenden Ansprüche, bei der die mindestens eine Induktivität (24, 24a, 24b, 24c, 24d, 24e, 24f, 24g, 24h) der mindestens einen Leitung (11, 11a, 11b, 11c, 11d, 11e, 11f) als Komponente mindestens eines Kerns ausgebildet ist, der die mindestens eine Leitung (11, 11a, 11b, 11c, 11d, 11e, 11f) des jeweiligen Satzes (10a, 10b, 10c) Leitungen (11, 11a, 11b, 11c, 11d, 11e, 11f) umschließt.

8. Schaltungsanordnung nach einem der voranstehenden Ansprüche, bei der parallel zu der mindestens einen Induktivität (24, 24a, 24b, 24c, 24d, 24e, 24f, 24g, 24h) der mindestens einen Leitung (11, 11a, 11b, 11c, 11d, 11e, 11f) eine Kapazität (26a, 26b, 26c, 26d, 26e, 26f, 26g) geschaltet ist.

9. Schaltungsanordnung nach einem der voranstehenden Ansprüche, bei der eine Resonanzfrequenz des mindestens einen Saugkreises (16, 16a, 16b, 16c, 16d, 16e, 16f, 16g, 16h) einen n-fachen Wert der Taktfrequenz aufweist, mit der das mindestens eine Bauteil (7) der Leistungselektronik (6) zu takten ist, wobei n eine ganze Zahl größer gleich 1 ist.

10. Schaltungsanordnung nach einem der voranstehenden Ansprüche, bei der der mindestens eine Saugkreis (16, 16a, 16b, 16c, 16d, 16e, 16f, 16g, 16h) eine Induktivität (22), eine Kapazität (32) und einen Widerstand (34) aufweist, die in Reihe geschaltet sind, wobei über einen Wert des Widerstands (34) eine Bandbreite des mindestens einen Saugkreises (16, 16a, 16b, 16c, 16d, 16e, 16f, 16g, 16h) einzustellen ist.

11. Bordnetz für ein Kraftfahrzeug, das eine Leistungselektronik (6) sowie mindestens eine damit verbundene Komponente umfasst, wobei die Leistungselektronik (6) mindestens ein Bauteil (7) umfasst, wobei die mindestens eine Komponente und das mindestens eine Bauteil (7) die über mindestens eine Leitung (11, 11a, 11b, 11c, 11d, 11e, 11f) miteinander verbunden sind, wobei das mindestens eine Bauteil (7) bei einem Betrieb der Leistungselektronik (6) mit einer Taktfrequenz zu takten ist, wobei das Bordnetz (2a, 2b, 2c) eine Schaltungsanordnung (14, 18, 20) nach einem der voranstehenden Ansprüche aufweist.

12. Bordnetz nach Anspruch 11, bei dem die mindestens eine Komponente als Energiespeicher (4) ausgebildet ist, der über einen Satz (10a, 10c) aus zwei Leitungen (11a, 11b, 11f) mit dem mindestens einen Bauteil (7) der Leistungselektronik (6) verbunden ist.

13. Bordnetz nach Anspruch 11 oder 12, bei dem die mindestens eine Komponente als Elektromaschine (8) ausgebildet ist, die über einen Satz (10b) aus drei Leitungen (11c, 11d, 11e) mit dem mindestens einen Bauteil (7) der Leistungselektronik (6) verbunden ist.

14. Bordnetz nach einem der Ansprüche 11 bis 13, bei dem die mindestens eine Komponente, das mindestens eine Bauteil (7) der Leistungselektronik (6) sowie die mindestens eine Leitung (11, 11a, 11b, 11c, 11d, 11e, 11f) als Bestandteile eines Geräts ausgebildet sind.

15. Bordnetz nach einem der Ansprüche 11 bis 14, bei dem die mindestens eine Leitung (11, 11a, 11b, 11c, 11d, 11e, 11f) von einem Kern aus einem Material umschlossen ist, das eine magnetische Permeabilität µ aufweist, die mindestens größer als 1 ist.

## Claims

1. Circuit arrangement for an electrical system (2, 2a, 2b, 2c) of a motor vehicle, wherein the circuit arrangement (14, 18, 20) comprises at least one absorption circuit (16, 16a, 16b, 16c, 16d, 16e, 16f, 16g, 16h) and the electrical system (2, 2a, 2b, 2c) has a power electronics (6) and at least one component connected thereto, wherein the power electronics (6) comprises at least one part (7) which must be clocked during operation of the power electronics (6) at a clock frequency, wherein the at least one part (7) is connected to the at least one component via at least one line (11, 11a, 11b, 11c, 11d, 11e, 11f), wherein the at least one line (11, 11a, 11b, 11c, 11d, 11e, 11f) has at least one inductance (24, 24a, 24b, 24c, 24d, 24e, 24f, 24g, 24h), wherein the at least one line (11, 11a, 11b, 11c, 11d, 11e, 11f) is assigned to the at least one absorption circuit (16, 16a, 16b, 16c, 16d, 16e, 16f, 16g, 16h) with an inductance (24, 24a, 24b, 24c, 24d, 24e, 24f, 24g, 24h) and a capacity, wherein the inductance (24, 24a, 24b, 24c, 24d, 24e, 24f, 24g, 24h) of the at least one absorption circuit (16, 16a, 16b, 16c, 16d, 16e, 16f, 16g, 16h) is coupled to the at least one inductance (24, 24a, 24b, 24c, 24d, 24e, 24f, 24g, 24h) of the at least one line (11, 11a, 11b, 11c, 11d, 11e, 11f).

2. Circuit arrangement according to claim 1, in which the at least one part (7) of the power electronics (6) is connected to the at least one component of the electrical system (2, 2a, 2b, 2c) via at least one set (10a, 10b, 10c) of lines (11, 11a, 11b, 11c, 11d, 11e, 11f), wherein each set (10a, 10b, 10c) of lines (11, 11a, 11b, 11c, 11d, 11e, 11f) has at least one inductance (24, 24a, 24b, 24c, 24d, 24e, 24f, 24g, 24h), wherein each set (10a, 10b, 10c) of lines (11, 11a, 11b, 11c, 11d, 11e, 11f) is respectively assigned to at least one absorption circuit (16, 16a, 16b, 16c, 16d, 16e, 16f, 16g, 16h) with an inductance (22), wherein the inductance (22) of the at least one absorption circuit (16, 16a, 16b, 16c, 16d, 16e, 16f, 16g, 16h) is coupled with the at least one inductance (24, 24a, 24b, 24c, 24d, 24e, 24f, 24g, 24h) of a respective set (10a, 10b, 10c) of lines (11, 11a, 11b, 11c, 11d, 11e, 11f).

3. Circuit arrangement according to claim 2, in which at least two lines (11, 11a, 11b, 11c, 11d, 11e, 11f) of a set (10a, 10b, 10c) of lines (11, 11a, 11b, 11c, 11d, 11e, 11f) respectively have a common inductance (24a, 24b, 24h), wherein each common inductance (24a, 24b, 24h) is assigned to an absorption circuit (16a, 16b, 16h), whose inductance (22) is coupled to the common inductance (24a, 24b, 24h).

4. Circuit arrangement according to claim 2 or 3, in which at least one line (11, 11a, 11b, 11c, 11d, 11e, 11f) respectively of a set (10a, 10b, 10c) of lines (11, 11a, 11b, 11c, 11d, 11e, 11f) has a separate inductance (24c, 24d, 24e, 24f, 24g), wherein each separate inductance (24c, 24d, 24e, 24f, 24g) is assigned to an absorption circuit (16, 16c, 16d, 16e, 16f, 16g), whose inductance (22) is coupled to the separate inductance (24c, 24d, 24e, 24f, 24g).

5. Circuit arrangement according to any one of claims 2 to 4, in which from two lines (11b, 11f) of a set (10c) of lines (11b, 11f) one first line (11b) runs straight and a second line (11f) comprises a loop (13), which is wound counter to the first line (11b), wherein the first line (11b) and the loop (13) of the second line (11f) have a common inductance (24h), wherein this common inductance (24h) is assigned to an absorption circuit (16, 16h), whose inductance (22) is coupled to the common inductance (24h).

6. Circuit arrangement according to any one of the preceding claims, in which the at least one inductance (24, 24a, 24b, 24c, 24d, 24e, 24f, 24g, 24h) of the at least one line (11, 11a, 11b, 11c, 11d, 11e, 11f) is designed as a throttle.

7. Circuit arrangement according to any one of the preceding claims, in which the at least one inductance (24, 24a, 24b, 24c, 24d, 24e, 24f, 24g, 24h) of the at least one line (11, 11a, 11b, 11c, 11d, 11e, 11f) is designed as a component of at least one core which encloses the at least one line (11, 11a, 11b, 11c, 11d, 11e, 11f) of the respective set (10a, 10b, 10c) of lines (11, 11a, 11b, 11c, 11d, 11e, 11f).

8. Circuit arrangement according to any one of the preceding claims, in which a capacity (26a, 26b, 26c, 26d, 26e, 26f, 26g) is switched parallel to the at least one inductance (24, 24a, 24b, 24c, 24d, 24e, 24f, 24g, 24h) of the at least one line (11, 11a, 11b, 11c, 11d, 11e, 11f).

9. Circuit arrangement according to any one of the preceding claims, in which a resonance frequency of the at least one absorption circuit (16, 16a, 16b, 16c, 16d, 16e, 16f, 16g, 16h) has an n-fold value of the clocked frequency at which the at least one part (7) of the power electronics (6) must be clocked, wherein n is a whole number greater than or equal to 1.

10. Circuit arrangement according to any one of the preceding claims, in which the at least one absorption circuit (16, 16a, 16b, 16c, 16d, 16e, 16f, 16g, 16h) has an inductance (22), a capacity (32) and a resistance (34) which are switched in series, wherein a bandwidth of the at least one absorption circuit (16, 16a, 16b, 16c, 16d, 16e, 16f, 16g, 16h) must be set over a value of the resistance (34).

11. Electrical system for a motor vehicle which comprises a power electronics (6) and at least one component connected thereto, wherein the power electronics (6) comprises at least one part (7), wherein the at least one component and the at least one part (7) are connected to one another via at least one line (11, 11a, 11b, 11c, 11d, 11e, 11f), wherein the at least one part (7) must be clocked during operation of the power electronics (6) at a clock frequency, wherein the electrical system (2a, 2b, 2c) has a circuit arrangement (14, 18, 20) according to any one of the preceding claims.

12. Electrical system according to claim 11, in which the at least one component is designed as an energy storage device (4) which is connected to the at least one part (7) of the power electronics (6) via a set (10a, 10c) of two lines (11a, 11b, 11f).

13. Electrical system according to claim 11 or 12, in which the at least one component is designed as an electric machine (8) which is connected to the at least one part (7) of the power electronics (6) via a set (10b) of three lines (11c, 11d, 11e).

14. Electrical system according to any one of claims 11 to 13, in which the at least one component, the at least one part (7) of the power electronics (6) and the at least one line (11, 11a, 11b, 11c, 11d, 11e, 11f) are designed as parts of a device.

15. Electrical system according to any one of claims 11 to 14, in which the at least one line (11, 11a, 11b, 11c, 11d, 11e, 11f) is enclosed by a core made of a material that has a magnetic permeability µ which is at least greater than 1.

## Revendications

1. Agencement de circuit pour un réseau de bord (2, 2a, 2b, 2c) d'un véhicule automobile, dans lequel l'agencement de circuit (14, 18, 20) comprend au moins un circuit résonant série (16, 16a, 16b, 16c, 16d, 16e, 16f, 16g, 16h) et le réseau de bord (2, 2a, 2b, 2c) une électronique de puissance (6) ainsi qu'au moins un constituant qui lui est connecté, dans lequel l'électronique de puissance (6) comprend au moins un composant (7) qui doit être synchronisé à une fréquence d'horloge lors d'un fonctionnement de l'électronique de puissance (6), dans lequel le au moins un composant (7) est connecté via au moins une ligne (11, 11a, 11b, 11c, 11d, 11e, 11f) au moins un constituant, dans lequel la au moins une ligne (11, 11a, 11b, 11c, 11d, 11e, 11f) présente au moins une inductance (24, 24a, 24b, 24c, 24d, 24e, 24f, 24g, 24h), dans lequel à la au moins une ligne (11, 11a, 11b, 11c, 11d, 11e, 11f) est affecté le au moins un circuit résonant série (16, 16a, 16b, 16c, 16d, 16e, 16f, 16g, 16h) avec une inductance (24, 24a, 24b, 24c, 24d, 24e, 24f, 24g, 24h) et une capacité, dans lequel l'inductance (24, 24a, 24b, 24c, 24d, 24e, 24f, 24g, 24h) du au moins un circuit résonant série (16, 16a, 16b, 16c, 16d, 16e, 16f, 16g, 16h) est couplée à la au moins une inductance (24, 24a, 24b, 24c, 24d, 24e, 24f) de la au moins une ligne (11, 11a, 11b, 11c, 11d, 11e, 11f).

2. Agencement de circuit selon la revendication 1, dans lequel le au moins un composant (7) de l'électronique de puissance (6) est connecté via au moins un ensemble (10a, 10b, 10c) de lignes (11, 11a, 11b, 11c, 11d, 11e, 11f) au moins un constituant du réseau de bord (2, 2a, 2b, 2c), dans lequel chaque ensemble (10a, 10b, 10c) de lignes (11, 11a, 11b, 11c, 11d, 11e, 11f) présente au moins une inductance (24, 24a, 24b, 24c, 24d, 24e, 24f, 24g, 24h), dans lequel à chaque ensemble (10a, 10b, 10c) de lignes (11, 11a, 11b, 11c, 11d, 11e, 11f) est affecté respectivement au moins un circuit résonant série (16, 16a, 16b, 16c, 16d, 16e, 16f, 16g, 16h) avec une inductance (22), dans lequel l'inductance (22) du au moins un circuit résonant série (16, 16a, 16b, 16c, 16d, 16e, 16f, 16g, 16h) est couplée à la au moins une inductance (24, 24a, 24b, 24c, 24c, 24e, 24f, 24g, 24h) d'un ensemble respectif (10a, 10b, 10c) de lignes (11, 11a, 11b, 11c, 11d, 11e, 11f).

3. Agencement de circuit selon la revendication 2, dans lequel au moins deux lignes (11, 11a, 11b, 11c, 11d, 11e, 11f) respectivement d'un ensemble (10a, 10b, 10c) de lignes (11, 11a, 11b, 11c, 11d, 11e, 11f) présentent une inductance (24a, 24b, 24h) commune, dans lequel à cette inductance (24a, 24b, 24h) commune est affecté un circuit résonant série (16a, 16b, 16h), dont l'inductance (22) est couplée à l'inductance (24a, 24b, 24h) commune.

4. Agencement de circuit selon la revendication 2 ou 3, dans lequel au moins une ligne (11, 11a, 11b, 11c, 11d, 11e, 11f) respectivement d'un ensemble (10a, 10b, 10c) de lignes (11a, 11a, 11b, 11c, 11d, 11e, 11f) présente une inductance propre (24c, 24d, 24e, 24f, 24g), dans lequel à chaque inductance propre (24c, 24d, 24e, 24f, 24g) est affecté un circuit résonant série (16, 16c, 16d, 16e, 16f, 16g), dont l'inductance (22) est couplée à l'inductance propre (24c, 24d, 24e, 24f, 24g).

5. Agencement de circuit selon l'une quelconque des revendications 2 à 4, dans lequel parmi deux lignes (11b, 11f) d'un ensemble (10c) de lignes (11b, 11f), une première ligne (11b) s'étend en ligne droite et une seconde ligne (11f) comprend une boucle (13) qui est enroulée en sens opposé de celui de la première ligne (11b), dans lequel la première ligne (11b) et la boucle (13) de la seconde ligne (11f) présentent une inductance (24h) commune, dans lequel à cette inductance (24h) commune est affecté un circuit résonant série (16, 16h) dont l'inductance (22) est couplée à l'inductance (24h) commune.

6. Agencement de circuit selon l'une quelconque des revendications précédentes, dans lequel la au moins une inductance (24, 24a, 24b, 24c, 24d, 24e, 24f, 24g, 24h) de la au moins une ligne (11, 11a, 11b, 11c, 11d, 11e, 11f) se présente sous la forme d'une bobine.

7. Agencement de circuit selon l'une quelconque des revendications précédentes, dans lequel la au moins une inductance (24, 24a, 24b, 24c, 24d, 24e, 24f, 24g, 24h) de la au moins une ligne (11, 11a, 11b, 11c, 11d, 11e, 11f) est conçue sous la forme d'un constituant d'au moins un noyau, qui entoure la au moins une ligne (11, 11a, 11b, 11c, 11d, 11e, 11f) de l'ensemble respectif (10a, 10b, 10c) de lignes (11a, 11a, 11b, 11c, 11d, 11e, 11f).

8. Agencement de circuit selon l'une quelconque des revendications précédentes, dans lequel, en parallèle avec la au moins une inductance (24, 24a, 24b, 24c, 24d, 24e, 24f, 24g, 24h) est commutée à la au moins une ligne (11, 11a, 11b, 11c, 11d, 11e, 11f) une capacité (26a, 26b, 26c, 26d, 26e, 26f, 26g).

9. Agencement de circuit selon l'une quelconque des revendications précédentes, dans lequel une fréquence de résonance du au moins un circuit résonant série (16, 16a, 16b, 16c, 16d, 16e, 16f, 16g, 16h) présente une valeur de n fois la fréquence d'horloge avec laquelle le au moins un composant (7) de l'électronique de puissance (6) doit être synchronisée, dans lequel n est un nombre entier supérieur ou égal à 1.

10. Agencement de circuit selon l'une quelconque des revendications précédentes, dans lequel le au moins un circuit résonant série (16, 16a, 16b, 16c, 16d, 16e, 16f, 16g, 16h) présente une inductance (22), une capacité (32) et une résistance (34) qui sont commutées en série, dans lequel une largeur de bande du au moins un circuit résonant série (16, 16a, 16b, 16c, 16d, 16e, 16f, 16g, 16h) doit être réglée via une valeur de la résistance (34).

11. Réseau de bord pour un véhicule automobile, qui comprend une électronique de puissance (6) ainsi qu'au moins un constituant qui lui est relié, dans lequel l'électronique de puissance (6) comprend au moins un composant (7) dans lequel le au moins un constituant et le au moins un composant (7) sont connectés l'un à l'autre via au moins une ligne (11, 11a, 11b, 11c, 11d, 11e, 11f), dans lequel le au moins un composant (7) doit être synchronisé avec une fréquence d'horloge lors d'un fonctionnement de l'électronique de puissance (6), dans lequel le réseau de bord (2a, 2b, 2c) présente un agencement de circuit (14, 18, 20) selon l'une quelconque des revendications précédentes.

12. Réseau de bord selon la revendication 11, dans lequel le au moins un constituant se présente sous la forme d'un accumulateur d'énergie (4) qui est connecté au moins un composant (7) de l'électronique de puissance (6) via un ensemble (10a, 10c) de deux lignes (11a, 11b, 11f).

13. Réseau de bord selon la revendication 11 ou 12, dans lequel le au moins un constituant se présente sous la forme d'une machine électrique (8) qui est connectée à au moins un composant (7) de l'électronique de puissance (6) via un ensemble (10b) de trois lignes (11c, 11d, 11e).

14. Réseau de bord selon l'une quelconque des revendications 11 à 13, dans lequel le au moins un constituant, le au moins un composant (7) de l'électronique de puissance (6) ainsi que la au moins une ligne (11, 11a, 11b, 11c, 11d, 11e, 11f) se présentent sous la forme de pièces d'un appareil.

15. Réseau de bord selon l'une quelconque des revendications 11 à 14, dans lequel la au moins une ligne (11, 11a, 11b, 11c, 11d, 11e, 11f) est confinée par un noyau constitué d'un matériau qui présente une perméabilité magnétique µ qui est au moins supérieure à 1.
